# EUROPEAN PATENT APPLICATION

(11) **EP 3 572 888 A1**
(43) Date of publication of application: **27.11.2019**
(21) Application number: 19183674.1
(22) Date of filing: 26.02.2015
(51) Int. Cl.: G05B 15/02, H02G 3/14, G06F 3/023, F24F 11/30

(54) **USER INTERFACE FOR A CONSUMER PRODUCT SYSTEM**

(30) Priority: 26.02.2014 AU 2014900625; 26.02.2014 AU 2014900632
(62) Divisional of application: 15755449.4
(71) Applicant: Zen Ecosystems IP Pty Ltd, Box Hill, VIC 3128 (AU)
(72) Inventor: DRUCE, Benjamin, Hawthorn, Victoria 3122 (AU); SEBASTIANI, Marco, Hawthorn East, Victoria 3123 (AU); STIMSON, Jeremy Phillip, Fitzroy, Victoria 3065 (AU); SMITH, Rohan, Warrandyte South, Victoria 3134 (AU); LOSCHER, Alina, Bentleigh East, Victoria 3165 (AU)
(74) Representative: J A Kemp LLP

(57) **Abstract**

A user interface is disclosed comprising a display region having an array of configurable button elements (63) operatively connected to processor means adapted to operate in accordance with a predetermined instruction set, said processor means, in conjunction with said instruction set, being adapted to either alone or in combination:activate a predetermined set of the button elements corresponding to a matching set of device nodes determined by the processor to be in operative connection for a user to control via the user interface, and; determine a set of device nodes that are in operative connection for a user to control via the user interface wherein the user interface is adapted for a user to activate a predetermined set of the button elements corresponding to a selection of the determined set of device nodes.

## Description

### RELATED APPLICATIONS

This application claims priority to Australian Provisional Patent Application No. 2014900625 in the name of Planet Intellectual Property Enterprises Pty Ltd, which was filed on 26 February 2014, entitled "Device Retention Means" and to Australian Provisional Patent Application No. 2014900632 in the name of Planet Intellectual Property Enterprises Pty Ltd, which was filed on 26 February 2014, entitled "Configurable User Interface" and the specifications thereof are incorporated herein by reference in their entirety and for all purposes.

### FIELD OF INVENTION

The present invention relates to the field of consumer product systems. It will be convenient to hereinafter describe the invention in relation to a wall mounted consumer product control device such as a thermostat, a lighting or appliance control panel, a relay control panel, a window covering control panel or, in another form a lighting switch, however it should be appreciated that the present invention may not be limited to those uses, only.

### BACKGROUND ART

Throughout this specification the use of the word "inventor" in singular form may be taken as reference to one (singular) inventor or more than one (plural) inventor of the present invention.

It is to be appreciated that any discussion of documents, devices, acts or knowledge in this specification is included to explain the context of the present invention. Further, the discussion throughout this specification comes about due to the realisation of the inventor and/or the identification of certain related art problems by the inventor. Moreover, any discussion of material such as documents, devices, acts or knowledge in this specification is included to explain the context of the invention in terms of the inventor's knowledge and experience and, accordingly, any such discussion should not be taken as an admission that any of the material forms part of the prior art base or the common general knowledge in the relevant art in Australia, or elsewhere, on or before the priority date of the disclosure and claims herein.

The inventor has recognised problems and disadvantages of conventional wall mounted control devices, for example, thermostats, light switches or the like.

An example of prior art comprises switch panels, for example, a typical set of three unlabelled light switches, which require trial and error to work out which switch does which of three or more lights or sets of lights.

Some exisiting switch panels contain pre-set numbers of buttons. In many cases, these are not all used and remain as "dummy" buttons or are replaced by blanking plates. In the location and environment in which these devices are installed it is increasingly important that the panels be aesthetically pleasing, easy and intuitive to use. Dummy buttons and blanking plates are ugly and may create confusion.

Other panels may use LCD screens that are configurable to have a certain number of buttons. This makes the user interface more intuitive but increases the cost and power consumption of the device.

Other designs may provide allowance for labelling of button panels, but this is usually done using visually unappealing labels which may not complement the interior design and look of the room (e.g. in the case of simple mechanical switches) or alternatively requires high-cost, high power LCD screens.

Consumers are reluctant to purchase and install home automation technology that does not fit, ruins or spoils the look and feel of the interior design of their homes. However, there is almost an infinite variety of configurations of switchable devices (e.g. lights) in the modern home. A button panel which is aesthetically pleasing, easy and intuitive whilst still being able to accomodate the variety of home configurations is therefore considered a commercially valuable offering.

Consumers who purchase and install "smart" devices like home automation controllers and button panels will not necessarily have the time or ability to undertake the full configuration of these device. Indeed, configuration of home automation systems is a multi-million dollar business. Therefore, a device which can automatically configure the type and number of buttons based, for example, on its knowledge of the wireless network to which it is attached, is anticipated to result in lower installion cost and simpler installation process.

Further to the above, the inventor has recognised problems and disadvantages of conventional retention methods for wall mounted devices like thermostats that use features such as snaps, clips, lugs or bayonets usually moulded in plastic housings to retain two mating parts that typically comprise a wall mounted part and a removable front cover or front housing part. Accordingly, disadvantages recognised by the inventor in the prior art stem from, a requirement for guiding one or both parts together through predetermined movements to either attach or remove the front housing. There is also the risk of damaging these mechanical structural retention features by missing the right installation path or routes, or in other words inadvertently guiding the front housing part off course leading to a misalignment when engaging or disengaging with the wall or mounted part. There exists also a risk of potentially breaking any structural retention features by dropping or hitting the instruments where structural retention features all present protruding parts which are prone to damage. There is also a loss of retention strength due to "creeping" of plastic materials.

In one example of prior art arrangements, the home products company, Nest™, have provided a 'Learning Thermostat', see www.nest.com. The Nest™ thermostat uses mechanical features to attach the front housing of a thermostat to its wall mount. In another example of prior art, Honeywell thermostats typically use mechanical latching features to retain the front housing to a wall mount.

An apparatus for mounting a device in a wall box is disclosed in the publication of US 2008/0190638 (Le), corresponding to granted US patent No. 7,414,193. The apparatus disclosed in Le is related in general to the field of wall box mountings and, more particularly, is related to magnetic and/or friction wall box mountings of devices. It is notable that all embodiments disclosed by Le involve three components for the mounting. Le describes and identifies problems in that wall boxes generally suffer from various disadvantages related to mounting. For instance, problems can arise if the wall box is skewed in any way after it has been mounted. In such a situation, the resulting light switch, light switch plate, or other device positioned in the wall box will appear to be similarly skewed resulting in an un-aesthetic appearance. Additionally, if the depth of the wall box mounting in the wall is too deep, the supplied screws may be too short to affix the light switch, light switch plate, or other device to the wall box. Further, if the mounted wall box is not parallel to the wall's surface, the mounting screws can become cross threaded, because the screw is not received perpendicularly in a receiving nut or tapped hole, leading to eventual failure of the mounting system. Problems may also arise in situations where a devices such as an infrared receiver or an infrared plate, is positioned in a skewed manner in the wall box. For example, the performance of the device can be affected if any equipment in communication with the device cannot adequately communicate because the device is not mounted properly. The problems described by Le, however, do not coincide with those identified by the inventor of the present invention. Moreover, Le does not contemplate the specific problems identified by the inventor herein.

The solution offered by Le includes an apparatus for mounting a device in a wall box that includes a base plate formed by a substantially flat front portion and a plurality of side portions extending to the rear to define a substantially open rear portion, and at least one magnet. The front portion is connected to a device. The base plate is configured to be substantially inserted into a magnetically engageable wall box arranged on a wall. Each magnet is connected to the base plate. At least one magnet is operably configured to magnetically engage an interior wall of the magnetically engageable wall box. As noted above, this configuration of essentially three separate components is substantiated in each embodiment described. An illustrative passage of a typical arrangement of Le is found at paragraph [0037] of the originally published specification. In each embodiment, the base plate 10 and the device 28 (which may be a thermostat) are required to fit within a magnetically engageable wall box.

It is considered that the device and system of Le involves unnecessary complexity in its requirement for the arrangement to include three components and, for example, at least the need to have the base plate inserted within a wall box.

Another prior art disclosure involving the housing and mounting of electronic components is that of US granted patent No. 7,858,886 (Helms et al). This disclosure relates generally to a housing for electronic equipment, and more particularly to a bracket for use in mounting the housing for electronic equipment, see column 1, lines 5-7. The problem(s) addressed by Helms et al are that connecting electrical components to a power source can be cumbersome and, additionally, replacing currently installed housings for electronic equipment can be a difficult and expensive task. This comes about because housings for electronic equipment, such as electrical transformers, are typically manufactured and sold as boxes with the electrical components already installed. Helms et al therefore identifies that there is a need for a structure that will allow for relatively quick and easy installation, or replacement, of housings for electronic equipment. The solution offered by Helms et al is a bracket for mounting a housing for accommodating electrical components and includes a base member capable of being mounted to a surface. The bracket may also include a sidewall extending from the base member and means for mounting the electrical component housing to the sidewall of the base member such that a space is defined between the base member and the electrical component housing. Also, in accordance with Helms et al, a housing assembly includes a housing member and a bracket capable of being fixed to a surface. The bracket includes a base member, a sidewall extending from the base member, and means for mounting the housing member to the sidewall of the base member. The housing assembly further includes means for removeably attaching the housing member to the mounting means. Importantly, the object of Helms et al appears to be that when the housing assembly is mounted to the bracket, the housing member is spaced from the base member. Further, in accordance with Helms et al, a method is provided for mounting a housing for accommodating electrical components. The disclosed method includes providing a bracket comprising a base capable of being mounted to a surface, at least one sidewall extending from the base, and means for mounting the electrical component housing to the at least one sidewall. The method may further comprise securing the bracket to a surface and mounting the electrical component housing to the bracket. In a general statement at column 4, lines 44-49 of Helms et al, relating specifically to mounting means between the sidewalls 32 of the wall mounted bracket 22 and the electrical component housing 24 of D3 it is stated that "various mounting means, other than the hook and slot system 78, may include pin and sleeve systems 80, pin and eyelet systems 82, hinges 84, hooks 86, magnets (not shown) and the like ..." Moreover, the "mounting means" described by Helms et al is restricted to mechanical integers to provide the retention of the mounting housing in the bracket for removeably securing the electrical component housing.

### SUMMARY OF INVENTION

It is an object of the invention and embodiments described herein to overcome or alleviate at least one of the above noted drawbacks of related or prior art systems or to at least provide a useful alternative to related or prior art systems.

In a first aspect of embodiments described herein there is provided a user interface comprising a display region having an array of configurable button elements operatively connected to processor means adapted to operate in accordance with a predetermined instruction set, said processor means, in conjunction with said instruction set, being adapted to activate a predetermined set of the button elements corresponding to a matching set of device nodes determined by the processor to be in operative connection for a user to control via the user interface.

In another aspect of the invention there is provided a user interface comprising a display region having an array of configurable button elements operatively connected to processor means adapted to operate in accordance with a predetermined instruction set, said processor means, in conjunction with said instruction set, being adapted to determine a set of device nodes that are in operative connection for a user to control via the user interface wherein the user interface is adapted for a user to activate a predetermined set of the button elements corresponding to a selection of the determined set of device nodes.

The user interface as disclosed in embodiments may further comprise display means operatively associated with the array of configurable button elements which is adapted to display the set of activated button elements. The display means preferably comprises one or a combination of:
a matrix of one or a combination of LED's, OLED's, incandescent or similar light sources;
icons illuminated by the matrix;
icons illuminated by a single light source.

Preferably, the predetermined set of the button elements of the user interface are activated by the user utilising one or a combination of:
a gesture-recognition sensing means, and;
a touch sensing means.

The button elements may operate independently of each other. Alternatively, the button elements may operate conditionally on a functional state of other button elements.

In preferred embodiments the user interface is adapted for operative association with a consumer device comprising one or a combination of:
a thermostat;
a lighting control panel.
an appliance control panel;
a relay control panel;
a security system control panel;
a window covering control panel.

In another aspect of embodiments described herein there is provided a method of releasably retaining a first portion with a second portion of a mounted electronic device, the method comprising the steps of:
locating the first portion in non-contacting proximity to the second portion of the electronic device such that at least one magnet located in one of the first or second portions exerts attractive force on at least one ferrous component of the other of the first or second portions such that the magnetic force guides the first portion into self-aligning contact with the second portion.

Preferably, the first portion and the second portion are one of: a front housing portion and a mounted portion of the electronic device, respectively; or a mounted portion and a front housing portion of the electronic device, respectively.

The at least one ferrous component may comprise one or a combination of:
fasteners;
metallic structural features of the device;
additional magnets.

In a preferable arrangement, the at least one magnet exerts attractive force on the head portion of the one or more fasteners. The at least one magnet located in one of the first or second portions may comprise a plurality of magnets located at the peripheral edges of the first or second portions.

Preferably, the at least one ferrous component of the other of the first or second portions comprises a plurality of fasteners that are located in positions at the peripheral edges of the first or second portions, which positions correspond to the locations of the magnets at the peripheral edges of the other of the first or second portions.

In yet another aspect of embodiments described herein there is provided a mounted electronic device comprising:
a front housing portion;
a mounted portion;
at least one magnet located in one of the mounted portion or the front housing portion;
at least one ferrous component located in the other of the front housing portion or the mounted portion, wherein the location of the magnets and ferrous components in the respective portions correspond for self-alignment such that when in proximity to each other the attractive force between the magnets and the ferrous components releasably retains the front housing portion to the mounted portion.

In a preferred device the ferrous components comprise fasteners. The fasteners in turn may comprise one or a combination of:
screws;
self-tapping screws;
lugs,
dowels
metal plates
or other magnets.

In a preferred device the attractive magnetic force is applied between the magnets and the head portions of the fasteners.

A preferred device is provided with the at least one ferrous component comprising one or a combination of:
fasteners;
metallic structural features of the device;
additional magnets.

The magnets of the device may be located in the peripheral edges of their respective portion and the ferrous components are located in corresponding peripheral edges of their respective portion for corresponding alignment with the magnets.

The device in a preferred form comprises a thermostat.

In a particularly preferred embodiment the fasteners associated with one of the two mating parts are, in combination with the magnets associated with the other of the two mating parts, arranged to correspond with the location of the magnets of the opposite part for magnetic engagement therewith to facilitate the self-alignment properties of the invention and also to obviate the need for a large magnetised metal surface on the opposite corresponding part to facilitate engagement with the magnets.

Other aspects and preferred forms are disclosed in the specification and/or defined in the appended claims, forming a part of the description of the invention.

In essence, embodiments of the present invention stem from the realization that selectively activating a set of button elements in an array of button elements to correspond to a predetermined set of actively connected devices will enable a fluid user interface display to be realised that can be housed in an aesthetically uniform manner. Further, embodiments of the present invention stem from the realization that the attractive force of magnetised parts can act as a retentive force and therefore will on the one hand obviate the necessity for mechanical or structural engaging fittings and, on the other hand will obviate the need for a user to guide a fitting part through predetermined movements in order to attach and/or remove a housing for a mounted part

Advantages provided by the present invention comprise the following.

Embodiments of the invention deliver an aesthetically pleasing, easy and intuitive to use panel, without any unnecessary buttons visible to the user.

A preferred embodiment of the invention uses simpler, cheaper LED and touch technology to deliver the same or better intutitive user interface at much lower cost and with much lower power consumption. The resultant lower power consumption means that embodiments of the invention can be used not only as a wall-mounted control panel, but also as a remote control panel, which can be located anywhere in an indoor environment such as a house or office building and operate on batteries for a number of months without recharging being required.

The advantages of having the ability to display an icon or image associated with each button is that the user is immediately aware of the action that each button press will do. The embodiments of the invention achieve this function using low cost and low power means. Further, the preferred embodiment of the invention also allows for the labels (and buttons) to be dimmed or powered off completely when not in use, which provides for a visually appealing look which can complement the interior design of a room

An exemplary embodiment of the invention is a method of quickly and reliably attaching and removing the front housing of a thermostat from its wall-mount plate using magnets. This method of retention overcomes the disadvantages of conventional retention methods for wall mounted devices like thermostats that use features such as snaps, clips, lugs or bayonets usually moulded in plastic housings.

The magnetic connection of embodiments of the present invention provides a reliable and user-friendly method of retention of mating parts. The magnets literally take the front housing out of a user's hands and stick it to the wall mount.

Embodiments of the present invention have advantages over the Nest™ and Honeywell prior art in that using magnets as retention means improve the user experience and durability of the product.

Advantageoiulsy the magnetic connection of embodiments is self-aligning, meaning that there are no features required to engage into one another for the system to work, particularly with the potential damage that this might cause. This also means that there are no predetermined paths, routes or movements that the user needs to learn prior to installing, for example, a front housing onto a wall mount plate, such as in bayonet or cantilever retention methods.

The magnetic connection works by simply bringing the two mating parts close enough for the magnets to attract the front housing and pull them together. They are guided into position by the geometries in the wall mount plate and the front housing and, preferably also by virtue of the location of the magnets and corresponding metal parts that are attracted by the magnets.

The magnetic connection is not subject to "creeping" that may be common in other retention methods that utilize plastic features or moulded plastic housings. It is advantageous to avoid creeping because, in time, creeping deteriorates and reduces the retention strength applied to these plastic mating parts.

The magnetic connection is not subject to damage by accidental hits or drops of the instrument. The housings of preferred embodiments have been designed so that they connect in a way that makes it very difficult to dislodge the front housing by bumping or knocking the unit.

Maintaining an aesthetically pleasing, easy and intuitive to use unit that is durable is important to the success of home consumer products. In this respect, the magnetic connection of preferred embodiments eliminates the possiblity of a non-functional unit due to wear or damage of a crucial mating feature.

As the system of preferred embodiments is self aligning and doesn't require prior learning by the user, it further reduces risk of damaging of the product and it improves the overall user experience by reducing the hassles involved with the installation of a new product.

Further scope of applicability of embodiments of the present invention will become apparent from the detailed description given hereinafter. However, it should be understood that the detailed description and specific examples, while indicating preferred embodiments of the invention, are given by way of illustration only, since various changes and modifications within the spirit and scope of the disclosure herein will become apparent to those skilled in the art from this detailed description.

### BRIEF DESCRIPTION OF THE DRAWINGS

Further disclosure, objects, advantages and aspects of preferred and other embodiments of the present invention may be better understood by those skilled in the relevant art by reference to the following description of embodiments taken in conjunction with the accompanying drawings, which are given by way of illustration only, and thus are not limitative of the disclosure herein, and in which:

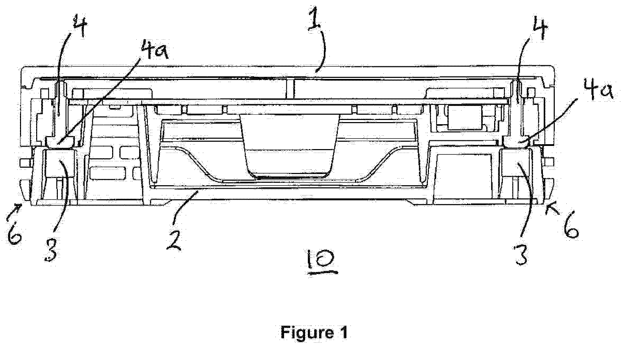

Figure 1 is a cross sectional side view of an exemplary thermostat unit comprising a wall mounting part coupled to a front housing part in accordance with a preferred embodiment of the present invention.
Figure 2a is a perspective view of a front housing of a thermostat device in accordance with a preferred embodiment of the present invention.
Figure 2b is a perspective view of a wall mount portion of a thermostat device in accordance with a preferred embodiment of the present invention corresponding to the front housing of figure 2a and illustrated in exploded view therewith.

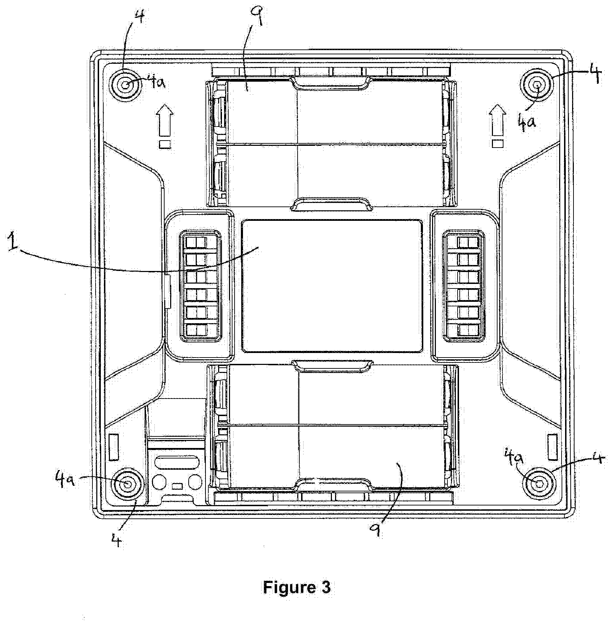

Figure 3 is a plan view of the front housing of figure 2a.

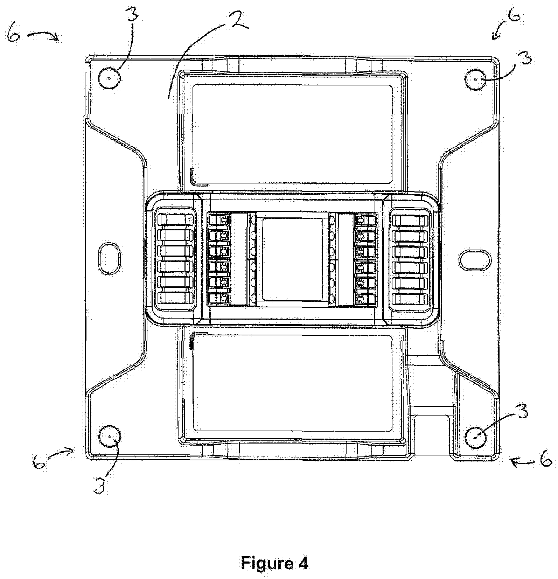

Figure 4 is a plan view of the wall mount portion of figure 2b.
Figure 5a is a perspective view of a user interface panel showing a first configuration of button elements in accordance with a preferred embodiment of the present invention.
Figure 5b is a perspective view of a user interface panel showing a second configuration of button elements in accordance with a preferred embodiment of the present invention.
Figure 5c is a perspective view of a user interface panel showing a third configuration of button elements in accordance with a preferred embodiment of the present invention.
Figure 6 is a cross sectional view of a user interface device in accordance with a preferred embodiment of the present invention.
Figure 7 is a perspective view of a user interface button display in accordance with another embodiment of the present invention.

### DETAILED DESCRIPTION

In one embodiment the present invention addresses the problems associated with retention means for wall mounted devices, like a thermostat, that commonly utilise plastic fastening mechanisms to retain two mating parts, ie a front housing to a wall mounted portion. The problems arise with these mechanical mountings from one or more of the following: a need for guiding the two mating parts through predetermined movements to engage; the risks of damaging the retention features by missing (overshooting etc) the correct installation path or route; the risk of breaking the retention features by dropping or hitting the instruments, noting that conventional retention features all present protruding parts which are prone to physical damage and; the loss of retention strength due to 'creeping' of plastic materials.

As disclosed and with reference to the accompanying drawings, a preferred solution offered by the inventor for a wall mounted thermostat device, denoted generally as 10, comprises a magnetic connection to retain a front housing 1 to a mounting 2 of the thermostat device 10. Such a thermostat device comprises:
a front housing portion 1;
a mounted portion 2;
magnets 3 located in the mounted portion 2;
fasteners 4 for securing parts of the device 10 located and retained in the front housing 1.

The fasteners 4 located in the front housing 1 are most preferably arranged for corresponding alignment to the positioning of the magnets 3 in the wall mount 2 such that the fasteners 4 come into close proximity to respective magnets 3 when the front housing 1 is moved toward engagement with the wall mount 2 and by attractive magnetic force the fasteners 4 and magnets 3 are self-aligning to guide the front housing 1 into aligned engagement with the wall mount 2.

Preferably magnets 3 are located in the mounted portion 2 in a distribution at the peripheral edges 6 of the mounted portion 2. The mounted portion 2 may comprise a wall mount for the device 10. Preferably, the fasteners 4 are self-tapping screws or the like that are arranged in the front housing 1 such that the head 4a of the screws 4 engages the magnets 3. The magnetic force exerted enables the front housing 1 to be releasably engaged with the wall mount 2 and prevent dislodgement by accidental knocks where only forces normal to the front face of the front housing 1 can dislodge the front housing 1 and lateral forces will not dislodge the front housing 1 from the wall mount 2 unless those forces are extreme.

The fasteners may comprise one or a combination of screws, self-tapping screws, lugs, dowels, metal plates, or other magnets.

In an alternate embodiment, as would be understood by the person skilled in the art, a form of kinematic inversion can be employed where the magnets 3 are located on the front housing portion 1 and the fasteners 4 are located on the mounted portion 2. Regardless of the respective locations of the magnets 3 and fasteners 4 that will be influenced by the attractive forces of the magnets 3, the same self-aligning function may be achieved. Further, in alternate embodiments, the fasteners 4 may be substituted by any corresponding ferrous components 4 being metallic structural features of the device 10 or, in fact additional magnets 4 that will be influenced by the attractive forces of the magnets 3 located in the opposing portion (1,2) of the device 10.

The self-aligning design of the preferred engagement means provides the advantages of improved useability where a user has no need to learn specific movements to engage the parts 1, 2 and durability is increased given that the likes of mechanical detents etc are obviated.

In a preferred embodiment of the present invention there is provided a thermostat 10 that uses a magnetic connection 3, 4 to retain the front housing 1 of the thermostat device 10 to the wall mounted portion 2 of the device 10.

The thermostat 10 is designed with a main front housing 1 and a wall mount 2. The front housing 1 contains fasteners, preferably four screws 4 which are arranged so that they come into close proximity with preferably four corresponding magnets 3 located in the wall mount 2 upon the housing 1 and wall mount 2 coming into mating proximity. In the preferred embodiment, four self-tapping screws 4 are utilised as they provide fastening to the whole front unit 1. They also provide the metallic attachment means for the magnets 3 through the screw heads 4a.

The design is such that the screws 4 and magnets 3 produce a force which retains the front housing 1 to the wall mount 2. This force is strong enough to provide strong retention whilst still allowing the user to remove the front housing 1 from the wall mount 2 should they wish to do so, for example, to replace batteries 9 that may be located in one or other of the front housing 1 or wall mount portion 2 of the device 10.

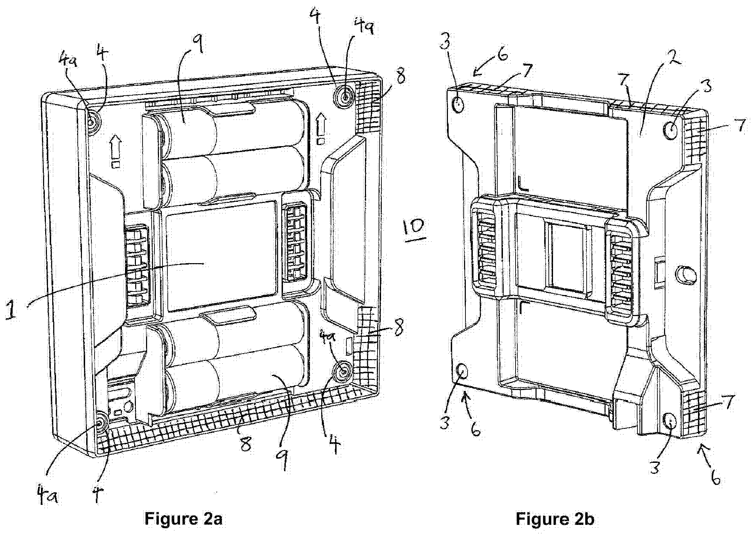

With reference to figures 2a and 2b, design features may be added to the device 10 to enhance the retention properties of the magnetic connection such as appropriately drafted surfaces 7, 8 on the respective wall mount 2 and front housing 1 portions so that accidental knocks and bumps wont dislodge the unit from the wall. Only forces 'normal' to the front face can dislodge the front housing 1 from the wall mount 2. Lateral forces will not dislodge the front housing 1 from the wall mount 2 unless they are of extreme force. Accordingly, drafted external walls 7 on the 'wall mount' 2 interface with the internal drafted faces 8 of the 'main housing' 1 establish secure alignment of the components ensuring that only forces normal to the front face can dislodge the components.

The ability for the user to retain and remove the front housing 1 from the wall-mount 2 using magnets 3 greatly improves the usability of the product. The magnetic connection is self-aligning, meaning that there are no features required to engage into one another for the system to work. This also means that there are no predetermined routes and movements that the user needs to learn prior to installing the front housing 1 onto the wall mount plate 2.

The use of magnets 3 also makes a mounted electronic product durable as there are no retention features that can break. The magnetic connection eliminates the possiblity of a non-functional unit due to wear or damage of a crucial mating feature.

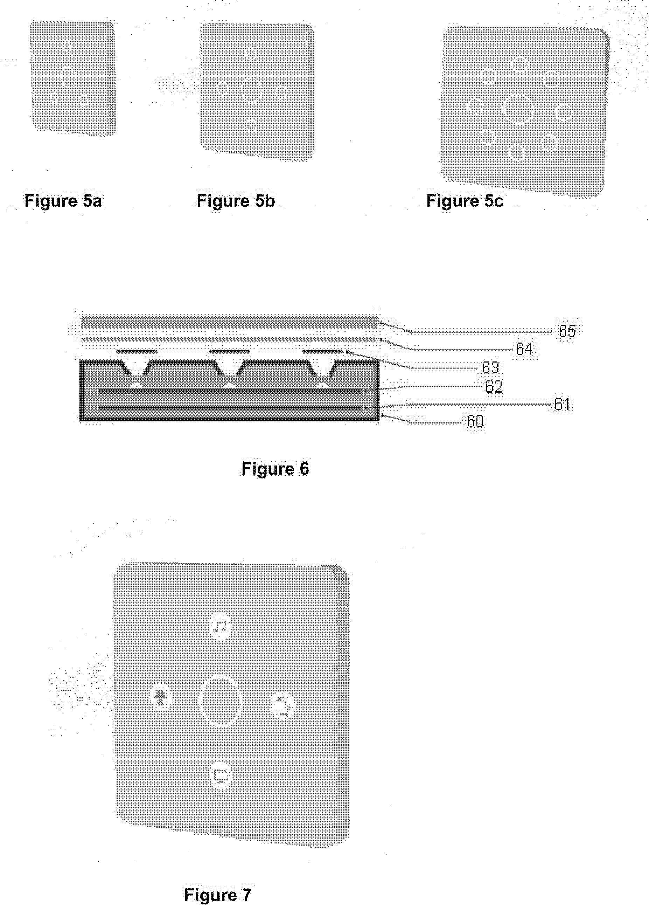

With reference to the accompanying drawings of figures 5a to 7, a wall mounted panel with an electronically configurable set of buttons designed to provide a visually appealing and architectural look is provided, whilst also providing identification of the function of each button and a means of communicating with a Home Autmation (HA) or Heating Ventillation and Cooling (HVAC) system to do an action when a button is pressed.

Overall, the inventor has considered that, an LED matrix capable of creating discernable icons may be very large and potentially more expensive than an LCD in such a configurable panel display of an interface. Moving clips or fixtures may also complicate and increase the cost. Other options such as using different coloured LEDs or alpha/numeric markers unique to each LED diffuser may not really add enough individuality to provide a cognitive link to the device they control to warrant inclusion. As is discussed herein, one feasible embodiment is to manually apply icon stickers or something similar that sit behind a front removable panel. However, in trying to identify what these icons would be that is both descriptive, easy to apply and does not detract from the clean aesthetic may be complex.

In a preferred embodiment a panel with a number of buttons which are arranged such that between 1 and x buttons can be enabled, and in each configuration the look of the panel is visually appealing and balanced. Enabling of each button can be done by the user, or preferably is automatically set by the wall panel by enumerating the number of associated devices (e.g lights, for a lighting control panel) based on their presence on a common wireless communications network (e.g devices on a Zigbee network). Each button can display a label that indicates its purpose (e.g light for the living room), that label being formed either by an image or character from a matrix of LED's or by the user manually inserting an image which is then optionally backlit by an LED. There may also be a central button which can be set to switch a number of devices at the same time. In its simplest form, it may turn everything on or off. The device may use a gesture-recognition sensor which identifies positions of a user touching out a set of discrete positions. Alternatively, it could also use capacitive or resistive touch buttons.

This preferred embodiment of the invention is a configurable retro fit interface for control of connected devices within the home. In a preferred embodiment, the present invention is suitable for use by being formed as a light switch or thermostat.

The preferred user interface device as shown in figure 6 comprises five key material layers housed within a durable wall mounted casing 60. At the base are the batteries 9 and control PCB 61. Next is the LED matrix 62, on top of this is a matrix of capacitive touch or gesture controlled buttons 63, the number of which matches with and are aligned with the LEDs. The third layer is the diffuser 64 which diffuses the LED light into a desired shape and consistency. The last layer is a glass or plastic panel 65 which is the touch interface for the user as a smooth and even surface. The smooth external surface created by the use of a touch interface makes the product easy to clean and increases durability as there are no moving parts.

In these embodiments, the present invention provides a device that is part of a wireless network (e.g. a Zigbee network) and would therefore have knowledge of the other elctronic devices, and their type, on the network. The device of the invention may thereby configure the button panel automatically based on the number and types of devices on the network. For example, if it is a light switch panel and there are four lights on the network, four buttons would be programmed to appear. By reducing the effort on the part of the user in configuring the device, this makes the user experience more simple and intuitive for a user.

As noted above, the device has a communcations module, such as Zigbee, which can link with other wireless enabled devices or nodes within the home. These can be any connected device which can be controlled in a binary (e.g on/off or may be 'smart light bulbs' or 'smart plugs') or a set of discrete (e.g. dimmable LED lights) states. The processing circuit within the device discerns how many of these nodes there are in the system and activate a matching number of buttons to control the main on/off function of each of the individual wireless node. Activation is defined as recognising a touch or button push and performing an action in response to this. In addition only the LEDs that correspond to the active buttons will be illuminated.

The device may be either battery or mains powered. The device can be permantly mounted to the wall, but can also be carried about the home. Accordingly, the funtion of the device is retained when mobile.

A central LED/capacitive switch combination is always active and controls the on/off function of all nodes in the system as a default setting. The function of this button can be reset to control the on/off function of the nodes currently 'on' by pressing and holding it for a prescribed duration.

The only elements that are visible to the user are the illuminated button locations/icons that correspond to the number of connected nodes in the system.

The examples of figures 5a, 5b and 5c illustrate the same switch in three different states. As shown, this example has a maxmimum of nine active buttons including the central all on/off button. Figure 5a corresponds to three nodes in the system to display three buttons/LEDs as enabled plus the central ALL on/off button as shown. Figure 5b indicates four nodes in the system to display four buttons/LEDs as enabled plus the central ALL on/off button. Figure 7 corresponds to eight nodes in the system to display eight buttons/LEDs as enabled plus the central ALL on/off button.

The circular arrangement of the buttons of figures 5a, 5b and 5c, distributed as shown, demonstrates that regardless of how many buttons are active, the device maintains a balanced and visually appealing aesthetic. Additionally, the device could be used in any orientation.

A square external profile is shown as for example in figure 7 but the device could also be of circular, hexagonal or other organic shapes which fit with the aims of being architecturally appropriate and balanced with the circular or radial arrangement of button positions.

In addtion to LED's, other equivalent light sources could be used, including but not limited to OLED's, incandescent, flouorescent or low cost LCD light sources.

For each active button, the function of the button can be further communicated to the user by display of an icon within the button area (e.g living room, bedroom, wall lamp, table lamp). One method of acheiving this is by placing a matrix of LED's on the LED layer, which are then selectively illuminated to display an icon. This icon can be configured remotely by the user through the network or can be deduced automatically by the devic based on the information about each node on the network (commonly available via a Zigbee network). Alternatively, the user can insert the icons (which would be supplied a seperate labels with the device) under the diffusion layer, such that the LED light illuminates the icon. This process would be entirely manual.

The funtion of the buttons can be independent but they can also be configured to operate conditionally on the state of other buttons. For example, three buttons could be used to represent high, low and medium settings for a single device (like a fan). Also, pressing one button might change the state or number of other buttons. The master on/off button is one case of this behaviour. Another example is where turning on a light in turn activates 2 more buttons for high and low illumination of that light. This behaviour means that when the light is off, the panel is in it's simplest state, making it easy for users to select and control devices to which it is connected. As the state of those devices change, the panel provides successively more ability to control the devices

While this invention has been described in connection with specific embodiments thereof, it will be understood that it is capable of further modification(s). This application is intended to cover any variations uses or adaptations of the invention following in general, the principles of the invention and including such departures from the present disclosure as come within known or customary practice within the art to which the invention pertains and as may be applied to the essential features hereinbefore set forth.

As the present invention may be embodied in several forms without departing from the spirit of the essential characteristics of the invention, it should be understood that the above described embodiments are not to limit the present invention unless otherwise specified, but rather should be construed broadly within the spirit and scope of the invention as defined in the appended claims. The described embodiments are to be considered in all respects as illustrative only and not restrictive.

Various modifications and equivalent arrangements are intended to be included within the spirit and scope of the invention and appended claims. Therefore, the specific embodiments are to be understood to be illustrative of the many ways in which the principles of the present invention may be practiced. In the following claims, means-plus-function clauses are intended to cover structures as performing the defined function and not only structural equivalents, but also equivalent structures. For example, although a nail and a screw may not be structural equivalents in that a nail employs a cylindrical surface to secure wooden parts together, whereas a screw employs a helical surface to secure wooden parts together, in the environment of fastening wooden parts, a nail and a screw are equivalent structures.

"Comprises/comprising" and "includes/including" when used in this specification is taken to specify the presence of stated features, integers, steps or components but does not preclude the presence or addition of one or more other features, integers, steps, components or groups thereof. Thus, unless the context clearly requires otherwise, throughout the description and the claims, the words 'comprise', 'comprising', 'includes', 'including' and the like are to be construed in an inclusive sense as opposed to an exclusive or exhaustive sense; that is to say, in the sense of "including, but not limited to".

### PREFERRED EMBODIMENTS

The claims of the parent application are reproduced immediately below as clauses. These clauses define preferred embodiments. The applicant reserves the right to pursue protection for the combinations of features set out in these clauses, and/or for any other subject-matter contained in the parent application as filed, either in the present divisional application or in a further application divided from the present divisional application. The claims of the parent application are not the claims of this divisional application. The claims of the current divisional application are contained in a subsequent section headed 'CLAIMS'.
1. A user interface comprising a display region having an array of configurable button elements operatively connected to processor means adapted to operate in accordance with a predetermined instruction set, said processor means, in conjunction with said instruction set, being adapted to activate a predetermined set of the button elements corresponding to a matching set of device nodes determined by the processor to be in operative connection for a user to control via the user interface.
2. A user interface comprising a display region having an array of configurable button elements operatively connected to processor means adapted to operate in accordance with a predetermined instruction set, said processor means, in conjunction with said instruction set, being adapted to determine a set of device nodes that are in operative connection for a user to control via the user interface wherein the user interface is adapted for a user to activate a predetermined set of the button elements corresponding to a selection of the determined set of device nodes.
3. A user interface as set out in clause 1 or 2 further comprising display means operatively associated with the array of configurable button elements which is adapted to display the set of activated button elements
4. A user interface as set out in clause 3 wherein the location of activated button elements upon the display region is predetermined by the processor means to be in a radially balanced arrangement.
5. A user interface as set out in clause 3 or 4 wherein the display means for each button element comprises one or a combination of:
   a matrix of one or a combination of LED's, OLED's, incandescent or similar light sources;
   icons illuminated by the matrix;
   icons illuminated by a single light source.
6. A user interface as set out in clause 2 wherein the predetermined set of the button elements are activated by the user utilising one or a combination of:
   a gesture-recognition sensing means, and;
   a touch sensing means.
7. A user interface as set out in any one of clauses 1 to 6 wherein the button elements operate independently of each other.
8. A user interface as set out in any one of clauses 1 to 6 wherein the button elements operate conditionally on a functional state of other button elements.
9. A user interface as set out in any one of clauses 1 to 8 wherein the user interface is adapted for operative association with a consumer device comprising one or a combination of:
   a thermostat;
   a lighting control panel;
   an appliance control panel;
   a relay control panel;
   a security system control panel;
   a window covering control panel.
10. A method of releasably retaining a first portion with a second portion of a mounted electronic device, the method comprising the steps of:
   locating the first portion in non-contacting proximity to the second portion of the electronic device such that at least one magnet located in one of the first or second portions exerts attractive force on at least one ferrous component of the other of the first or second portions such that the magnetic force guides the first portion into self-aligning contact with the second portion.
11. A method as set out in clause 10 wherein the first portion and the second portion are one of:
   a front housing portion and a mounted portion of the electronic device, respectively;
   a mounted portion and a front housing portion of the electronic device, respectively.
12. A method as set out in clause 10 or 11 wherein the at least one ferrous component comprises one or a combination of:
   fasteners;
   metallic structural features of the device;
   additional magnets.
13. A method as set out in clause 12 wherein the at least one magnet exerts attractive force on the head portion of the one or more fasteners.
14. A method as set out in any one of clauses 10 to 13 wherein the at least one magnet located in one of the first or second portions comprises a plurality of magnets located at the peripheral edges of the first or second portions.
15. A method as set out in clause 14 wherein the at least one ferrous component of the other of the first or second portions comprises a plurality of fasteners that are located in positions at the peripheral edges of the first or second portions, which positions correspond to the locations of the magnets at the peripheral edges of the other of the first or second portions.
16. A mounted electronic device comprising:
   a front housing portion;
   a mounted portion;
   at least one magnet located in one of the mounted portion or the front housing portion;
   at least one ferrous component located in the other of the front housing portion or the mounted portion, wherein the location of the magnets and ferrous components in the respective portions correspond for self-alignment such that when in proximity to each other the attractive force between the magnets and the ferrous components releasably retains the front housing portion to the mounted portion.
17. A device as set out in clause 16 wherein the ferrous components comprise fasteners.
18. A device as set out in clause 17 wherein the fasteners comprise one or a combination of:
   screws;
   self-tapping screws;
   lugs,
   dowels
   metal plates
   or other magnets.
19. A device as set out in any one of clauses 17 or 18 wherein the attractive magnetic force is applied between the magnets and the head portions of the fasteners.
20. A device as set out in clause 16 wherein the at least one ferrous component comprises one or a combination of:
   fasteners;
   metallic structural features of the device;
   additional magnets.
21. A device as set out in any one of clauses 16 to 20 wherein the magnets are located in the peripheral edges of their respective portion and the ferrous components are located in corresponding peripheral edges of their respective portion for corresponding alignment with the magnets.
22. A device as set out in any one of clauses 16 to 21 wherein the device comprises a thermostat.
23. A method and/or protocol as herein disclosed.
24. A system, apparatus and / or device as herein disclosed.

## Claims

1. A user interface comprising a display region having an array of configurable button elements operatively connected to processor means adapted to operate in accordance with a predetermined instruction set, **characterised by** said processor means, in conjunction with said instruction set, being adapted to either alone or in combination:
activate a predetermined set of the button elements corresponding to a matching set of device nodes determined by the processor to be in operative connection for a user to control via the user interface, and;
determine a set of device nodes that are in operative connection for a user to control via the user interface wherein the user interface is adapted for a user to activate a predetermined set of the button elements corresponding to a selection of the determined set of device nodes.

2. A user interface as claimed in claim 1 further comprising display means operatively associated with the array of configurable button elements which is adapted to display the set of activated button elements

3. A user interface as claimed in claim 2 wherein the location of activated button elements upon the display region is predetermined by the processor means to be in a radially balanced arrangement.

4. A user interface as claimed in claim 2 or 3 wherein the display means for each button element comprises one or a combination of:
a matrix of one or a combination of LED's, OLED's, incandescent or similar light sources;
icons illuminated by the matrix;
icons illuminated by a single light source.

5. A user interface as claimed in claim 1 wherein the predetermined set of the button elements are activated by the user utilising one or a combination of:
a gesture-recognition sensing means, and;
a touch sensing means.

6. A user interface as claimed in any one of claims 1 to 5 wherein the button elements operate independently of each other.

7. A user interface as claimed in any one of claims 1 to 5 wherein the button elements operate conditionally on a functional state of other button elements.

8. A user interface as claimed in any one of claims 1 to 7 wherein the user interface is adapted for operative association with a wall mounted consumer product control device comprising one or a combination of:
a thermostat;
a lighting control panel;
an appliance control panel;
a relay control panel;
a security system control panel;
a window covering control panel.

9. A user interface as claimed in claim 8 wherein the wall mounted consumer product control device comprises:
a front housing portion; and,
a mounted portion wherein the front housing portion is releasably retained in the mounted portion.

10. A user interface as claimed in claim 9 wherein the front housing portion is releasably retained in the mounted portion by magnets.
